# EUROPEAN PATENT APPLICATION

(11) **EP 4 848 955 A1**
(43) Date of publication of application: **02.12.2026**
(21) Application number: 24883600.9
(22) Date of filing: 29.07.2024
(51) Int. Cl.: H10K 59/12

(54) **DISPLAY PANEL AND MANUFACTURING METHOD THEREFOR, AND DISPLAY DEVICE**

(30) Priority: 25.06.2024 CN 202410826731; 24.01.2024 CN 202410103694
(71) Applicant: Wuhan China Star Optoelectronics Semiconductor Display Technology Co., Ltd., Wuhan, Hubei 430079 (CN)
(72) Inventor: XU, Feng., Wuhan, Hubei 430079 (CN)
(74) Representative: Herrero & Asociados, S.L.
(86) International application number: PCT/CN2024/108044
(87) International publication number: WO 2025/156584

(57) **Abstract**

The disclosure provides a display panel and a method for preparing the same, and a display device. The display panel includes a pixel definition layer, a light-emitting device layer, and a dimming structure layer; the pixel definition layer is provided with a plurality of first openings accommodating light-emitting devices; the dimming structure layer includes a first dimming layer provided with a plurality of second openings corresponding to the first openings, a second dimming layer at least covering a sidewall of the second openings, and a refractive index of the first dimming layer is greater than a refractive index of the second dimming layer and less than a refractive index of the third dimming layer.

## Description

### TECHNICAL FIELD

The disclosure relates to the field of display, and in particular, to a display panel and a method for preparing the same, and a display device.

### BACKGROUND

Compared to liquid crystal display (LCD) panels, organic light-emitting diode (OLED) display panels have characteristics of self-luminescence, thinness, high contrast, wide viewing angle, bright color, and the like. In addition, the OLED display panels usually have thicknesses much thicker than the LCD panels, and thus can be made into various forms of display devices such as a bent form, a curved form, and a curled form, making them widely used in wearable devices.

Generally, the OLED display panels include light-emitting devices for emitting light and display. However, at present, the light-emitting devices in the OLED display panels often have a large light-emitting angle, resulting in lower brightness of the OLED display panels at a front viewing angle.

### SUMMARY

Embodiments of the disclosure provide a display panel and a method for preparing the same, and a display device, which improves the problem of low brightness of display panels at a front viewing angle in related art.

In a first aspect, some embodiments of the disclosure provide a display panel, which includes a driving substrate, a pixel definition layer, a light-emitting device layer, an encapsulation layer, and a dimming structure layer. The pixel definition layer and the light-emitting device layer are disposed on the driving substrate, the pixel definition layer is provided with a plurality of first openings, the light-emitting device layer includes a plurality of light-emitting devices, and each of the light-emitting devices is disposed in one of the first openings; the encapsulation layer is disposed on a side of the light-emitting device layer away from the driving substrate; the dimming structure layer is disposed on a side of the encapsulation layer away from the driving substrate, and includes a first dimming layer, a second dimming layer, and a third dimming layer sequentially arranged in a direction away from the driving substrate; the first dimming layer is provided with a plurality of second openings corresponding to the first openings, the second dimming layer at least covers a sidewall of the second openings, and the third dimming layer at least fills one of the second openings; and a refractive index of the first dimming layer is greater than a refractive index of the second dimming layer and less than a refractive index of the third dimming layer.

In a second aspect, some embodiments of the disclosure further provide a display device including the display panel as described above.

In a third aspect, some embodiments of the disclosure further provide a method for preparing a display panel, which includes: providing a driving substrate; forming a pixel definition layer and a light-emitting device layer on the driving substrate, in which the pixel definition layer is provided with a plurality of first openings, the light-emitting device layer includes a plurality of light-emitting devices, and each of the light-emitting devices is disposed in one of the first openings; forming an encapsulation layer on a side of the light-emitting device layer away from the driving substrate; and forming a dimming structure layer on a side of the encapsulation layer away from the driving substrate, in which the dimming structure layer includes a first dimming layer, a second dimming layer, and a third dimming layer sequentially arranged in a direction away from the driving substrate; the first dimming layer is provided with a plurality of second openings corresponding to the first openings, the second dimming layer at least covers a sidewall of the second openings, and the third dimming layer at least fills one of the second openings; and a refractive index of the first dimming layer is greater than a refractive index of the second dimming layer and less than a refractive index of the third dimming layer.

### BRIEF DESCRIPTION OF THE DRAWINGS

In order to explain technical solutions in embodiments of the disclosure more clearly, the following will briefly introduce the drawings needed to be used in description of the embodiments. Apparently, the drawings in the following description are only some embodiments of the disclosure. For ordinary skilled in the art, other drawings can be obtained from these drawings without paying creative effort.
FIG. 1 is a sectional diagram of a display panel provided in some embodiments of the disclosure.
FIG. 2 is a sectional diagram of a display panel provided in other embodiments of the disclosure.
FIG. 3 is a sectional diagram of a display panel provided in other embodiments of the disclosure.
FIG. 4 is a flowchart of a method for preparing a display panel provided in some embodiments of the disclosure.
FIG. 5 is a flowchart of a method for preparing a display panel provided in other embodiments of the disclosure.

### DETAILED DESCRIPTION

The following will provide a clear and complete description of technical solutions in embodiments of the disclosure in conjunction with the drawings. Apparently, the following embodiments are only a part of the embodiments of the disclosure, not all of them. Based on the embodiments of the disclosure, all other embodiments obtained by those skilled in the art without creative labor are within the scope of protection of the disclosure. Furthermore, it can be understood that specific embodiments described herein are only for illustration and explanation of the disclosure and are not intended to limit the disclosure.

In the description of the disclosure, it can be understood that directional or positional relationships indicated by the terms "length", "width", "thickness", "above", "below", "front", "back", "left", "right", "top", "bottom", "inside", "outside", and the like, are based on the directional or positional relationships shown in the drawings, only for the convenience of describing the disclosure and simplifying the description, rather than indicating or implying that the devices or elements referred to must have a specific direction, be constructed and operated in a specific direction, and therefore cannot be interpreted as a limitation on the disclosure.

In addition, the terms "first" and "second" are only used for the purpose of description and cannot be understood as indicating or implying relative importance or implying the quantity of technical features indicated. Therefore, the features limited to "first" and "second" may explicitly or implicitly include one or more of the features. In the description of the disclosure, "a plurality of" refers to two or more than two, and "at least one" refers to one, two, or more than two, unless otherwise specified.

In related art, light-emitting devices in OLED display panels often have a large light-emitting angle, resulting in lower brightness of the OLED display panels at a front viewing angle.

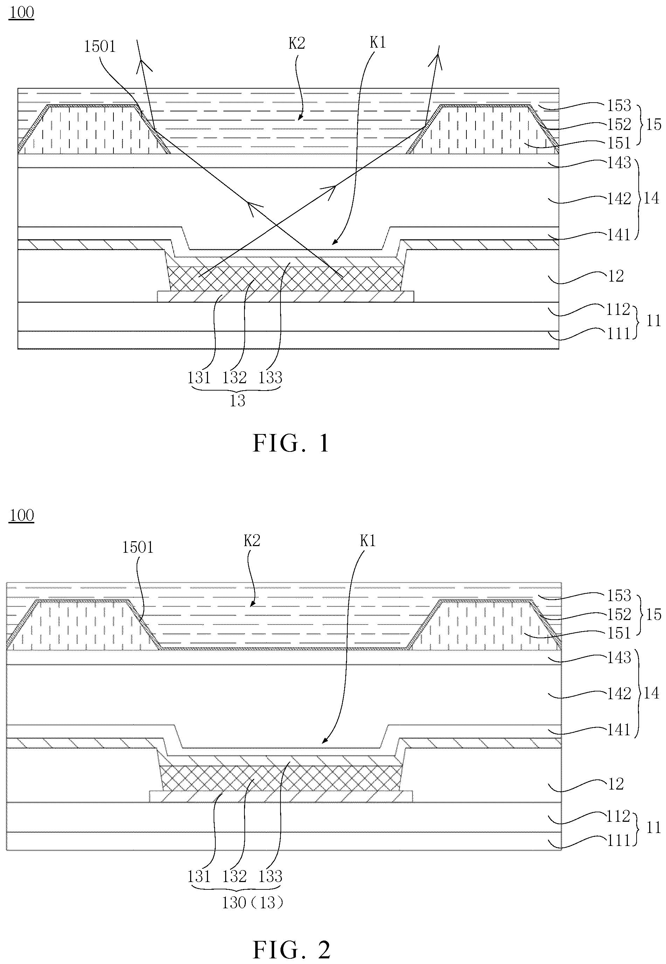

To solve the above problem, some embodiments of the disclosure provide a display panel. As illustrated in FIGs. 1 to 3, a display panel 100 includes a driving substrate 11, a pixel definition layer 12, a light-emitting device layer 13, an encapsulation layer 14, and a dimming structure layer 15.

The pixel definition layer 12 is provided with a plurality of first openings K1, and the light-emitting device layer 13 includes a plurality of light-emitting devices 130 disposed on the driving substrate 11, and each of the light-emitting devices 130 is disposed in one of the first openings K1. That is, the number of the first openings K1 is the same as the number of the light-emitting devices 130, and the first openings K1 are disposed in one-to-one correspondence with the light-emitting devices 130. The encapsulation layer 14 is disposed on a side of the light-emitting device layer 13 away from the driving substrate 11 and covers the light-emitting devices 130.

The dimming structure layer 15 is disposed on a side of the encapsulation layer 14 away from the driving substrate 11. The dimming structure layer 15 includes a first dimming layer 151, a second dimming layer 152, and a third dimming layer 153 sequentially arranged in a direction away from the driving substrate 11. The first dimming layer 151 is provided with a plurality of second openings K2 corresponding to the first openings K1. The second dimming layer 152 at least covers a sidewall 1501 of one of the second openings K2. The third dimming layer 153 at least fills one of the second openings K2.

A refractive index of the first dimming layer 151 is greater than a refractive index of the second dimming layer 152 and less than a refractive index of the third dimming layer 153, so that a larger difference is formed between the refractive index of the second dimming layer 152 and the refractive index of the third dimming layer 153, and contact surfaces of the second dimming layer 152 and the third dimming layer 153 can form a good transition interface located at the sidewall of one of the second openings K2.

As illustrated in FIG. 1, when light emits by one of the light-emitting devices 130, enters the third dimming layer 153 from a bottom of one of the second openings K2, and is incident on the transition interface, since the light is incident from a material with a high refractive index on a material with a low refractive index, total reflection is prone to occur, causing the light originally emitted from the third dimming layer 153 to be reflected into a front viewing angle, thereby increasing the brightness at the front viewing angle and improving the light output efficiency.

Based on the above, the display panel 100 provided in the embodiments of the disclosure can effectively adjust light and converge the light that originally diverged towards a large viewing angle into a front viewing angle, thereby improving the brightness at the front viewing angle and improving the light output efficiency.

In some embodiments, the driving substrate 11 includes a base 111 and a driving circuit layer 112 disposed on the base 111. The driving circuit layer 112 is configured to drive the light-emitting devices 130 of the light-emitting device layer 13, thereby achieving the luminescence of the light-emitting devices 130.

In some embodiments, the base 111 can be a rigid base. For example, a material of the rigid base may include a glass, quartz, plastic, or the like.

In some embodiments, the base 111 can be a flexible base. A material of the flexible base may include polyethylene terephthalate (PET), polyethylene terephthalate (PEN), polyimide (PI), or the like.

In some embodiments, the driving circuit layer 112 includes a plurality of pixel driving circuits electrically connected to the light-emitting devices. Specific connection methods between the pixel driving circuits and the light-emitting devices can be selected according to actual requirements, which are not limited herein.

In some embodiments, the pixel driving circuits are connected to the light-emitting devices 130 in one-to-one correspondence. Alternatively, one of the pixel driving circuits can be electrically connected to a plurality of light-emitting devices 130; and alternatively, a plurality of pixel driving circuits can be electrically connected to one of the light-emitting devices 130.

In some embodiments, the plurality of light-emitting devices 130 are arranged in an array, and the plurality of pixel driving circuits are arranged in an array either, thereby facilitating the corresponding connection between the two.

The embodiments of the disclosure take each of the pixel driving circuits being electrically connected to one of the light-emitting devices 130 as an example, to describe the structure of the display panel 100.

In some embodiments, as illustrated in FIGs. 1 to 3, each of the light-emitting devices 130 includes an anode 131 disposed on the driving substrate 11, and a light-emitting functional layer 132 and a cathode 133 sequentially stacked on the anode 131.

A plurality of anodes 131 of the plurality of light-emitting devices 130 are disposed individually, and a gap is formed between any adjacent two anodes 131. In some embodiments, the plurality of anodes 131 can be arranged in an array.

A plurality of cathodes 133 of the plurality of light-emitting devices 130 are connected to each other to form a cathode layer. For example, the cathode layer can be prepared by a whole evaporation process, so that the encapsulation layer 14 is disposed on a side of the cathode layer away from the driving substrate 11.

The light-emitting functional layer 132 includes an emission layer (EML) for emitting light. A plurality of emission layers of the plurality of light-emitting devices 130 can be disposed individually, and a gap is formed between any adjacent two emission layers. In some embodiments, the plurality of emission layers can be disposed in one-to-one correspondence with the plurality of anodes.

In some embodiments, the light-emitting functional layer 132 further includes a first common layer disposed between the anode and the emission layer, and a second common layer disposed between the emission layer and the cathode. The first common layer includes, but not limited to at least one of a hole injection layer (HIL) and a hole transport layer (HTL). The second common layer includes, but not limited to at least one of an electron injection layer and an electron transport layer (ETL). In some embodiments, both of the first common layer and the second common layer are disposed as whole layers.

In some embodiments, the anodes 131 are electrically connected to the pixel driving circuits in one-to-one correspondence, so that each of the anodes 131 receives a driving signal from one of the pixel driving circuits. The cathodes 133 receive a reference voltage signal. The emission layers in the light-emitting functional layer 132 emit light after receiving the driving signal and the reference voltage signal. The mutual cooperation of the plurality of light-emitting devices 130 can achieve the image display of the display panel 100.

In some embodiments, the light-emitting devices 130 are top-emitting type of light-emitting devices. The anodes 131 can be electrodes that are basically opaque and have higher reflectivity, and the cathodes 133 can be transparent or semi-transparent electrodes. For example, a material of the cathodes 133 includes, but not limited to, magnesium (Mg), silver (Ag), aluminum (Al), an alloy of magnesium and silver, indium tin oxide (ITO), or the like.

The encapsulation layer 14 located above the light-emitting devices 130 can be used to prevent oxidation or damage to the light-emitting devices 130 caused by moisture, oxygen, or impurities introduced from outside.

The encapsulation layer 14 may include a first encapsulation layer 141, a second encapsulation layer 142, and a third encapsulation layer 143 sequentially stacked on the light-emitting device layer 13.

Materials of the first encapsulation layer 141 and the third encapsulation layer 143 may include an inorganic material, such as silicon nitride, silicon oxide, silicon oxynitride, and the like. The inorganic material has high density to prevent the invasion of moisture, oxygen, and the like. For example, the first encapsulation layer 141 and the third encapsulation layer 143 can be formed by a chemical vapor deposition.

A material of the second encapsulation layer 142 may include an organic material, such as a polymer material containing desiccants, or a polymer material that can block moisture, such as polymer resin. In some embodiments, the second encapsulation layer 142 can be formed by an inkjet printing process.

In some embodiments, a touch structure is provided on a side of the encapsulation layer 14 away from the light-emitting device layer 13. The touch structure may include a first touch metal layer, an inorganic insulating layer, a second touch metal layer arranged sequentially. The inorganic insulating layer may include silicon nitride. Specifically, the first dimming layer 151 is an organic layer disposed on a side of the second touch metal layer away from the encapsulation layer 14, and the organic layer can protect and flatten the touch structure. Therefore, the second openings K2 corresponding to the first openings K1 is disposed in the first dimming layer 151, and then a film layer with a higher refractive index is filled in the second openings K2, so that the light output efficiency of the display panel at the front viewing angle is improved using the principle of total reflection.

In some embodiments, the display panel does not include a film layer having a refractive index meeting the conditions for filling into the second openings K2. If the film layer having the refractive index meeting the above-mentioned conditions is additionally provided, for example, adding ink having a high refractive index by printing, it will undoubtedly add a manufacturing process and is not conducive to the thinning of the thickness of the display panel. Moreover, during the process for printing ink having a high refractive index, it is difficult to avoid the overflow of the ink, and the overflowing ink will occupy a certain space of a frame, which is not conducive to the narrow frame design of the display panel.

To solve the above problem, in some embodiments, the third dimming layer 153 adopts an adhesive layer. That is, the adhesive layer is filled in the second openings K2 of the first dimming layer 151, so that functional layers of the display panel 100 can be bonded to a side of the first dimming layer 151 away from the encapsulation layer 14 through the adhesive layer. Therefore, setting the third dimming layer 153 as the adhesive layer does not additionally increase the thickness of the display panel 100. Moreover, since the adhesive layer is a whole sheet material, there will be no overflow that occupies the space of the frame, which is conducive to the thinning and narrow frame design of the display panel 100.

In some embodiments, the display panel 100 further includes a polarization functional layer disposed on a side of the dimming structure layer 15 away from the encapsulation layer 14. The third dimming layer 153 is an adhesive layer bonded to a surface of the polarization functional layer close to the dimming functional layer 15. That is, the third dimming layer 153 is directly bonded to the polarization functional layer. In the manufacturing process, the third dimming layer 153 can be an adhesive layer inherent in the polarization functional layer, therefore, the third dimming layer 153 does not additionally increase the thickness of the display panel 100, which is conducive to the thinning of the display panel 100.

In some embodiments, the third dimming layer 153 is an adhesive layer, and the adhesive layer includes an acrylic double bond and a benzene ring. The addition of the acrylic with the double bond can ensure the viscosity of the third dimming layer 153. The addition of the benzene ring can increase the refractive index of the third dimming layer 153, so that the refractive index of the third dimming layer 153 is greater than the refractive index of the first dimming layer 151. However, the addition of the benzene ring will increase the rigidity of the third dimming layer 153 and enable the third dimming layer 153 to have insufficient deformation ability, affecting the viscosity of the third dimming layer 153. Therefore, in order to balance the viscosity and the refractive index of the third dimming layer 153, on the basis that the refractive index of the third dimming layer 153 is greater than the refractive index of the first dimming layer 151, it is difficult to achieve a large difference between the refractive index of the third dimming layer 153 and the refractive index of the first dimming layer 151. According to the principle of total reflection, the larger the difference in refractive index between the third dimming layer 153 and the first dimming layer 151, the more conducive it is to improving the light output efficiency at the front viewing angle. Therefore, if the total reflection is achieved only through the cooperation of the first dimming layer 151 and the third dimming layer 153, the improvement in the light output efficiency of the display panel at the front viewing angle is limited.

It should be noted that, in the actual manufacturing process, the first dimming layer 151 is an organic layer disposed above the touch structure, and the organic layer is formed by a front-end process for preparing the display panel; and the third dimming layer 153 is an adhesive layer that directly bonds to the functional layers of the display panel, and the adhesive layer is formed by a back-end process for preparing the display panel. After the front-end process for preparing the display panel is completed, a protective film needs to be bonded to a surface of the display panel, so as to protect the display panel, and avoid damage to the display panel during the transfer and switch from the front-end process to the back-end process. After the display panel is transferred and switched to the back-end process, the protective film bonded in the front-end process needs to be torn off first. The protective film includes a protective film body and a release agent layer disposed on a side of the protective film body close to the first dimming layer 151. During the process for tearing off the protective film, it is difficult to avoid the residue of the release agent layer.

On the basis of the above embodiments, the residual release agent layer is used as the second dimming layer 152, and the refractive index of the second dimming layer 152 is set to be less than the refractive index of the first dimming layer 151. Moreover, adjustments made to the manufacturing process can be provided to ensure that the second dimming layer 152 at least uniformly remains on the sidewall of one of the second openings K2 of the first dimming layer 151, and then, the total reflection will occur at the interface between the third dimming layer 153 and the second dimming layer 152. Since the difference between the refractive index of the third dimming layer 153 and the second dimming layer 152 is greater than the difference between the refractive index of the third dimming layer 153 and the first dimming layer 151, the setting of the second dimming layer 152 can further improve the light output efficiency of the display panel at the front viewing angle.

In some embodiments, the second dimming layer 152 at least includes an organic substance, and the organic substance in the second dimming layer 152 is different from a material of the first dimming layer 151 being the organic layer, so that the refractive index of the second dimming layer 152 is different from the refractive index of the first dimming layer 151.

Furthermore, the organic substance in the second dimming layer 152 includes a moiety of -NH-COO-, which can not only meet the requirements of the second dimming layer 152 as a release agent layer, but also meet the requirement that the refractive index of the second dimming layer 152 is less than the refractive index of the first dimming layer 151. In practical applications, a material of the second dimming layer 152 includes polyurethane. In some embodiments, the second dimming layer 152 can be made of other materials, as long as it meets both of the requirements of the second dimming layer 152 as the release agent layer and the refractive index requirements within the scope of the disclosure, and is not specifically limited herein.

In the embodiments of the disclosure, the refractive index of the first dimming layer 151 is greater than the refractive index of the second dimming layer 152 and less than the refractive index of the third dimming layer 153, so that a larger difference is formed between the refractive index of the second dimming layer 152 and the refractive index of the third dimming layer 153, and contact surfaces of the second dimming layer 152 and the third dimming layer 153 can form a good transition interface. When light emits by one of the light-emitting devices 130, enters the third dimming layer 153 from a bottom of one of the second openings K2, and is incident on the transition interface, since the light is incident from a material with a high refractive index on a material with a low refractive index, total reflection is prone to occur, causing the light originally emitted from the third dimming layer 153 to be reflected into a front viewing angle, thereby increasing the brightness at the front viewing angle and improving the light output efficiency. Moreover, since the second dimming layer 152 adopts the residual release agent layer during the manufacturing process of the display panel, and the third dimming layer 153 is used as the adhesive layer of bonding functional layers of the display panel, the settings of the second dimming layer 152 and the third dimming layer 153 do not increase the manufacturing processes of the display panel while improving the light output efficiency of the display panel at the front viewing angle, which is conducive to simplifying the manufacturing process of the display panel.

In some embodiments, the third dimming layer 153 includes a polar functional group having low molecular weight to attach polyurethane, so as to improve the joining degree of the interface between the second dimming layer 152 and the third dimming layer 153, and avoid a decrease in the joining degree of the interface between the second dimming layer 152 and the third dimming layer 153 after being placed for a period of time.

In some embodiments, the third dimming layer 153 is prone to be affected by ion wind during the manufacturing process. Under the action of the ion wind, the viscosity of the third dimming layer will be reduced to a certain extent. Therefore, the polar functional group having low molecular weight in the third dimming layer 153 that attach polyurethane are embedded in the middle of the acrylic double bond, reducing the steric effect of the functional group and increase the viscosity of the third dimming layer 153 during the manufacturing process.

Unlike the above embodiments where the benzene ring is added to the structure of the third dimming layer 153 to increase the refractive index of the third dimming layer 153, in some embodiments, the third dimming layer 153 is doped with particles with a high refractive index to increase the refractive index of the third dimming layer 153, but it is still necessary to ensure that the refractive index of the third dimming layer 153 is greater than the refractive index of the first dimming layer 151, and to ensure the viscosity of the third dimming layer 153 used as the adhesive layer.

In some embodiments, the second openings K2 penetrate through the first dimming layer 151, and an area of a side of one of the second openings K2 away from the driving substrate 11 is greater than an area of a side of one of the second openings K2 close to the driving substrate 11. That is, one of the second openings K2 has a structure with one end larger and another end smaller. For example, one of the second openings K2 can be in a shape of an inverted truncated cone, which can effectively increase a light-emitting area of corresponding one of the light-emitting devices 130. In this case, the sidewall 1501 is an inclined sidewall with an outward opening in a direction from the driving substrate 11 towards the dimming structure layer 15.

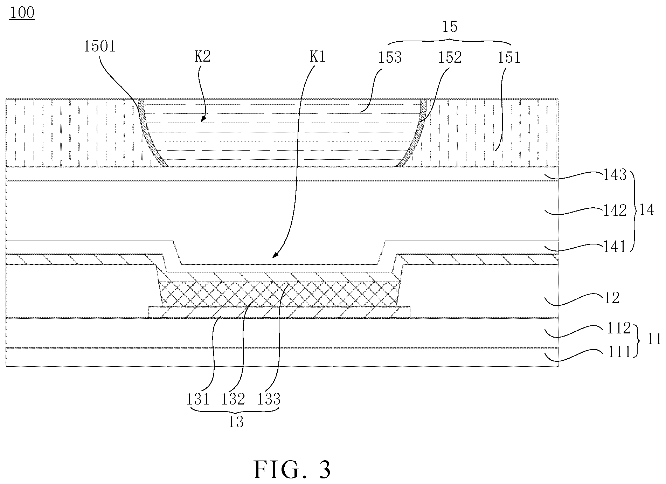

In some embodiments, as illustrated in FIG. 3, the second dimming layer 152 only covers the sidewall 1501 of one of the second openings K2.

With the above setting, a transition interface can be formed between the second dimming layer 152 and the third dimming layer 153 at the sidewall 1501 of one of the second openings K2, which can effectively adjust the light emitted towards the sidewall 1501 of one of the second openings K2, thereby allowing more light to be reflected into the front viewing angle, and further improving the brightness at the front viewing angle.

In some embodiments, the sidewall 1501 is a curved surface, as illustrated in FIG. 3. In some embodiments, the sidewall 1501 is a flat surface, as illustrated in FIG. 1 and FIG. 2. In other embodiments, the sidewall 1501 can be a combination of a curved surface and a flat surface, or have other forms, which are not limited herein.

In some embodiments, as illustrated in FIG. 1, in addition to covering the sidewall 1501 of one of the second openings K2, the second dimming layer 152 also covers a surface of the first dimming layer 151 away from the driving substrate 11.

With the above setting, when the light emitted by one of the light-emitting devices 130 enters the first dimming layer 151 through a bottom surface of the first dimming layer 151 (a surface of the first dimming layer 151 close to the driving substrate 11), exits from a top surface of the first dimming layer 151 (a surface of the first dimming layer 151 away from the driving substrate 11), and then enters the second dimming layer 152 and reaches the interface between the second dimming layer 152 and the third dimming layer 153, since the light is incident from a material with a low refractive index on a material with a high refractive index, more light will refract, which is conducive to improving a light extraction rate of the light-emitting devices 130.

In some embodiments, as illustrated in FIG. 2, in addition to covering the sidewall 1501 of one of the second openings K2, the second dimming layer 152 also covers a surface of the encapsulation layer 14 (e.g., the third encapsulation layer 143) at one of the second openings K2. In practical applications, a touch structure is further provided on a side of the encapsulation layer 14 away from the light-emitting device layer 13. A touch metal layer of the touch structure is set to avoid the first openings K1, and a film layer of the touch structure corresponding to the first openings K1 is an inorganic insulating layer. Therefore, in the case where the second openings K2 penetrate through the first dimming layer 151, the bottom of one of the second openings K2 exposes the inorganic insulating layer of the touch structure. And thus, the second dimming layer 152 covers the bottom of one of the second openings K2, indicating that the second dimming layer 152 covers the surface of the inorganic insulating layer at one of the second openings K2.

With the above setting, when light emitted by one of the light-emitting devices 130 is incident on the second dimming layer 152 through the bottom of one of the second openings K2, and then enters the interface between the second dimming layer 152 and the third dimming layer 153, since the light is incident from a material with a high refractive index on a material with a low refractive index, more light will refract, which is conducive to improving the light extraction rate of the light-emitting devices 130.

In some embodiments, as illustrated in FIG. 2, the second dimming layer 152 is disposed as a whole layer, and the second dimming layer 152 covers the first dimming layer 151 and one of the second openings K2. Therefore, the second dimming layer 152 can form a continuous layer, which ensures that the light-emitting devices 130 have good light output efficiency and brightness at the front viewing angle, and is conducive to the preparation of the second dimming layer 152.

In some embodiments, the first dimming layer 151 is provided with a plurality of second openings K2, which are disposed in one-to-one correspondence with the plurality of light-emitting devices 130 of the light-emitting device layer 13.

The second dimming layer 152 can completely cover the first dimming layer 151, and cover the encapsulation layer 14 at the second openings of the first dimming layer 151. That is, the first dimming layer 151 and the encapsulation layer 14 can be combined as a whole, and then the second dimming layer 152 is formed thereon.

In some embodiments, the second dimming layer 152 has a thickness greater than or equal to 10 nm and less than or equal to 100 nm, which is conducive to reducing an overall thickness of the dimming structure layer 15, thereby reducing a thickness of the display panel 100. Moreover, setting the thickness of the dimming structure layer 15 in the above range is conducive to ensuring a better brightness of the display panel 100 at the front viewing angle.

Comparative experiments were conducted for the second dimming layer 152 under the condition of different thicknesses. Taking the second dimming layer 152 having a thickness of 0 (that is, the second dimming layer 152 is omitted) as a comparative experiment, when the second dimming layer 152 has a thickness of 30 nm, 50 nm, or 100 nm, the current efficiency increased significantly. However, when the second dimming layer 152 has a thickness greater than 100 nm or less than 10 nm, the current efficiency decreased significantly compared to the range of 10 nm to 100 nm. Therefore, setting the dimming structure layer 15 having the thickness of 10 nm to 100 nm can improve the brightness of the display panel 100 at the front viewing angle.

In some embodiments, the second dimming layer 152 has a thickness greater than or equal to 30 nm and less than or equal to 60 nm. Within this range, on the one hand, it can avoid the situation where the thickness of the second dimming layer 152 is too small to ensure a stable transition interface between the second dimming layer 152 and the third dimming layer 153, which may cause a decrease of the brightness at the front viewing angle. On the other hand, it can ensure that the dimming structure layer 15 has a reasonable and relatively small thickness.

During the experimental process, it was found that a better current efficiency can be achieved by setting the second dimming layer 152 having a thickness of 30 nm to 60 nm compared to the range of 10 nm and 100 nm (such as the range of 10 nm to 20 nm, 70 nm to 80 nm, and 80 nm to 90 nm). Therefore, setting the dimming structure layer 15 having the thickness of 30 nm to 60 nm can more significantly and effectively improve the brightness of the display panel 100 at the front viewing angle.

In some embodiments, on the basis of forming a stable transition interface between the second dimming layer 152 and the third dimming layer 153, setting the second dimming layer 152 having the thickness close to 100 nm is more conducive to the use in actual manufacturing processes.

In some embodiments, an absolute value of a difference between the refractive index of the first dimming layer 151 and the refractive index of the second dimming layer 152 is less than an absolute value of a difference between the refractive index of the first dimming layer 151 and the refractive index of the third dimming layer 153. It should be noted that, the first dimming layer 151 is an organic layer disposed on a side of the touch structure of the display panel 100 that is away from the encapsulation layer 14, the second dimming layer 152 is a residual release agent layer after tearing off the protective film during the process for preparing the display panel 100, and the third dimming layer 153 is an adhesive layer for bonding the functional layers of the display panel 100. Considering limitations on the functions of the first dimming layer 151, the second dimming layer 152, and the third dimming layer 153 in the display panel 100, the absolute value of the difference between the refractive index of the first dimming layer 151 and the refractive index of the second dimming layer 152 will be limited. Under the above limitations, the absolute value of the difference between the refractive index of the second dimming layer 152 and the refractive index of the first dimming layer 151 is set to be less than the absolute value of the difference between the refractive index of the first dimming layer 151 and the refractive index of the third dimming layer 153. Therefore, in order to achieve the functions of the first dimming layer 151, the second dimming layer 152, and the third dimming layer 153 in the display panel 100, there can be a relatively larger difference between the refractive index of the second dimming layer 152 and the refractive index of the third dimming layer 153, so as to further improve the light output efficiency of the display panel 100 at the front viewing angle.

In some embodiments, the second dimming layer 152 has a refractive index greater than or equal to 1.4 and less than 1.5, and the third dimming layer 153 has a refractive index greater than or equal to 1.55 and less than or equal to 1.6.

In some embodiments, the second dimming layer 152 has a refractive index of 1.4, 1.45, 1.5, or the like; and the third dimming layer 153 has a refractive index of 1.55, 1.56, 1.57, 1.58, 1.59, 1.6, or the like.

The above setting can achieve a larger difference between the refractive index of the second dimming layer 152 and the refractive index of the third dimming layer 153, which not only meets the requirements for improving the brightness at the front viewing angle, but also facilitates the preparation of the second dimming layer 152 and the third dimming layer 153.

In addition, when the third dimming layer 153 has a refractive index of 1.55 to 1.6, the third dimming layer 153 has good viscosity to maintain good stability of the display panel 100, and has strong deformation ability to achieve the bending of the display panel 100.

In some embodiments, the third dimming layer 153 is an adhesive layer that can be used to bond components disposed on a side of the second dimming layer 152 away from the driving substrate 11, such as a polarizer and other components, which is conducive to reducing the number of film layers, simplifying manufacturing processes of the display panel 100, and achieving the narrow frame and the bending of the display panel 100.

In some embodiments, the third dimming layer 153 adopts organic adhesives. For example, the third dimming layer 153 may include a material such as acrylic ester, polymethyl methacrylate, or the like.

In some embodiments, the second dimming layer 152 has a refractive index greater than or equal to 1.45 and less than or equal to 1.48, for example, 1.45, 1.46, 1.47, 1.48, or the like.

The second dimming layer 152 has the refractive index in the above range, which can not only ensure that the transition interface between the second dimming layer 152 and the third dimming layer 153 effectively improves the brightness of the display panel 100 at the front viewing angle, but also contribute to preparing the second dimming layer 152.

In some embodiments, the second dimming layer 152 includes at least one of a fluorine-containing organic compound and organosilicon. Both of the fluorine-containing organic compound and organosilicon have relatively small refractive indices, which can make the refractive index of the second dimming layer 152 less than the refractive index of the third dimming layer 153, so that light emitted from the third dimming layer 153 towards the sidewall can be effectively reflected, thereby improving the utilization rate for light energy and improving the brightness at the front viewing angle.

In some embodiments, the fluorine-containing organic compound can be a fluorine-containing release agent.

In some embodiments, the second dimming layer 152 also includes resin, and the fluorine-containing organic compound or the organosilicon used as a release agent can be distributed on the surface of the resin. For example, the fluorine-containing organic compound or the organosilicon can be uniformly distributed on the surface of the resin.

After the encapsulation layer 14 of the display panel 100 is formed on the light-emitting device layer 13, the first dimming layer 151 is formed on the encapsulation layer 14, and then a protective film is bonded to the first dimming layer 151. The protective film includes a protective film body and a release agent layer disposed on a side of the protective film body. The release agent layer is disposed on a side of the protective film body close to the first dimming layer 151. The protective film can be extruded towards a side of the first dimming layer 151 through processes such as a defoaming treatment, the protective film body is torn off, and then the residual release agent layer is used as the second dimming layer 152.

The above method makes the process for preparing the second dimming layer 152 simple, avoiding the use of vapor deposition or a sputtering process during the preparation of nano or submicron film layers of the display panel, thereby reducing the processes and improving production efficiency of the display panel 100.

In some embodiments, in the case where the second dimming layer 152 includes the fluorine-containing organic compound, fluorine atoms in the second dimming layer 152 has an atomic proportion greater than 0 and less than 10% by mass. That is, compared to other elements, fluorine atoms in the second dimming layer 152 has an atomic proportion less than 10% by mass.

Within the above range, the content of the fluorine-containing organic compound is relatively reasonable. On the one hand, it can ensure that the refractive index of the second dimming layer 152 is within the above range. On the other hand, it is conducive to ensuring the smooth tearing off of the release film.

In some embodiments, the fluorine atoms in the second dimming layer 152 has an atomic proportion greater than 0 and less than 5% by mass.

Through experimental measurement, it was found that when the atomic proportion is within the above range, the second dimming layer 152 has a refractive index of 1.45 to 1.48, enabling the display panel to have a better utilization rate for light energy and better brightness at the front viewing angle.

In some embodiments, when the second dimming layer 152 includes organosilicon, silicon atoms in the second dimming layer 152 has an atomic proportion greater than 0 and less than 10% by mass.

Within the above range of atomic proportion, the organosilicon has a relatively reasonable content. On the one hand, it can ensure that the second dimming layer 152 has a refractive index within the above range, and on the other hand, it is conducive to ensuring the smooth tearing off of the release film.

In some embodiments, the silicon atoms in the second dimming layer 152 has an atomic proportion greater than 0 and less than 5% by mass.

Through experimental measurement, it was found that when the atomic proportion is within the above-mentioned range, the second dimming layer 152 has a refractive index of 1.45 to 1.48, enabling the display panel to have a better utilization rate for light energy and better brightness at the front viewing angle.

In some embodiments, the first dimming layer 151 has a refractive index greater than or equal to 1.5 and less than or equal to 1.53. The first dimming layer 151 is mainly used to form the second openings K2 and provide the sidewall 1501, so that the second dimming layer 152 can be stably attached to the sidewall 1501.

In some embodiments, the first dimming layer 151 can be made from transparent optical adhesives.

In practical applications, due to the deviation between the actual manufacturing process and the design value, the first dimming layer 151 has a refractive index close to 1.52, the second dimming layer 152 has a refractive index close to 1.5, and the third dimming layer 153 has a refractive index close to 1.6. As such, the refractive index of the first dimming layer 151 is greater than the refractive index of the second dimming layer 152 and less than the refractive index of the third dimming layer 153, and the absolute value of the difference between the refractive index of the first dimming layer 151 and the refractive index of the third dimming layer 153 is less than the absolute value of the difference between the refractive index of the second dimming layer 152 and the refractive index of the third dimming layer 153. That is, there is a relatively larger difference between the refractive index of the second dimming layer 152 and the refractive index of the third dimming layer 153, thereby maximizing the light output efficiency of the display panel 100 at the front viewing angle.

In some embodiments, an orthographic projection of a bottom of one of the second openings K2 on the driving substrate 11 at least partially overlaps with an orthographic projection of corresponding one of the light-emitting devices 130 on the driving substrate 11, so that at least part light emitted by one of the light-emitting devices 130 can reach the sidewall of corresponding one of the second openings K2, thereby forming total reflection at the interface between the third dimming layer 153 and the second dimming layer 152 at the sidewall of one of the second openings K2, and further improving the light output efficiency of the display panel at the front viewing angle.

In some embodiments, the orthographic projection of the bottom of one of the second openings K2 on the driving substrate 11 completely overlaps with the orthographic projection of corresponding one of the light-emitting devices 130 on the driving substrate 11.

The above setting ensures that more light emitted by the light-emitting devices 130 can enter the second openings K2 and exit from the second openings K2. By adjusting the transition interface at the inner sidewall of the second openings K2, the brightness at the front viewing angle can be effectively improved, and the output efficiency of the light-emitting devices 130 can be enhanced.

In some embodiments, the orthographic projection of the bottom of one the second openings K2 on the driving substrate 11 covers the orthographic projection of corresponding one of the light-emitting devices 130 on the driving substrate 11.

The above setting can increase the proportion of light emitted by the light-emitting devices 130 that enters the second openings K2, thereby greatly enhancing the brightness at the front viewing angle, and improving the light output efficiency of the light-emitting devices 130.

For the display panel 100 provided in the above embodiments, the following experimental measurements were performed: the display panel 100 without the second dimming layer 152 was taken as experimental sample 1, and the display panel 100 including the second dimming layer 152 was taken as experimental sample 2. Under the same experimental conditions, the following three sets of data were measured. Compared to the experiment sample 1, brightness of the experiment sample 2 at the front viewing angle increased by 5.08%, 6.36%, and 6.69%, respectively. Therefore, compared to the experimental sample 1, the average improvement ratio of the brightness of the experiment sample 2 at the front viewing angle can reach 6.04%. And thus, in the embodiments provided by the disclosure, the brightness of the display panel 100 at the front viewing angle can increase by at least 5%, which has a huge gain for the use of the display panel 100.

Some embodiments of the disclosure provide a display device, which includes the display panel 100 as described in any of the above-mentioned embodiments.

The display device including the display panel has all the technical effects of the display panel 100 as discussed above, and will not be repeated here.

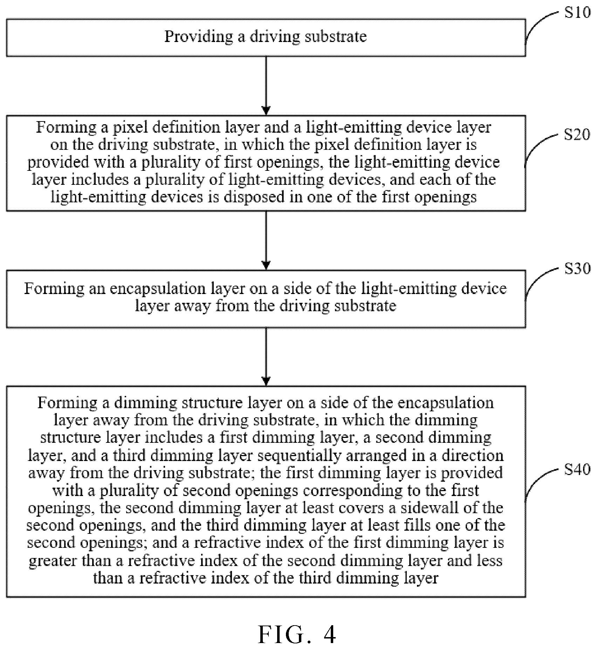

As illustrated in FIG. 4, some embodiments of the disclosure further provide a method for preparing the display panel 100, including the following steps.

Step S10, providing the driving substrate 11.

Step S20, forming the pixel definition layer 12 and the light-emitting device layer 13 on the driving substrate 11. The pixel definition layer 12 is provided with a plurality of first openings K1, the light-emitting device layer 13 includes a plurality of light-emitting devices 130, and each of the light-emitting devices 130 is disposed in one of the first openings K1.

Step S30, forming the encapsulation layer 14 on a side of the light-emitting device layer 13 away from the driving substrate 11.

Step S40, forming the dimming structure layer 15 on a side of the encapsulation layer 14 away from the driving substrate 11. The dimming structure layer 15 includes the first dimming layer 151, the second dimming layer 152, and the third dimming layer 153 sequentially arranged in a direction away from the driving substrate 11. The first dimming layer 151 is provided with a plurality of second openings K2 corresponding to the first openings K1, the second dimming layer 152 at least covers the sidewall 1501 of one of the second openings K2, and the third dimming layer 153 at least fills one of the second openings K2. The refractive index of the first dimming layer 151 is greater than the refractive index of the second dimming layer 152 and less than the refractive index of the third dimming layer 153.

With the above setting, when light emits by one of the light-emitting devices 130, enters the third dimming layer 153 from a bottom of one of the second openings K2, and is incident on the transition interface, since the light is incident from a material with a high refractive index on a material with a low refractive index, total reflection is prone to occur, causing the light originally emitted from the third dimming layer 153 to be reflected into a front viewing angle, thereby improving the brightness at the front viewing angle and improving the light output efficiency.

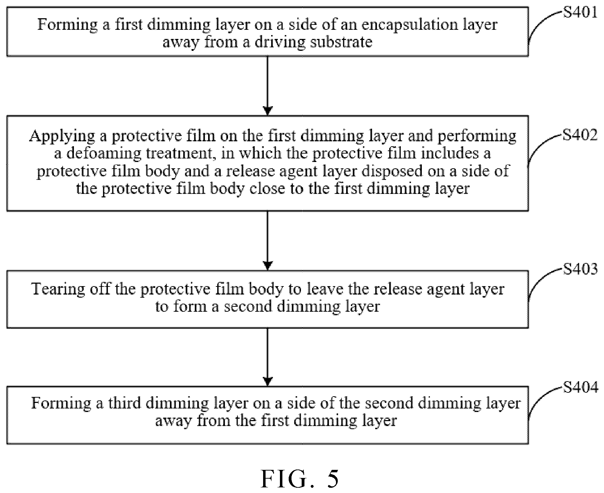

In some embodiments, as illustrated in FIG. 5, in step S40, the step of forming the dimming structure layer 15 on a side of the encapsulation layer 14 away from the driving substrate 11, includes the following steps.

Step S401, forming the first dimming layer 151 on a side of the encapsulation layer 14 away from the driving substrate 11.

Step S402, applying a protective film on the first dimming layer 151 and performing a defoaming treatment. The protective film includes a protective film body and a release agent layer disposed on a side of the protective film body close to the first dimming layer 151.

Step S403, tearing off the protective film body to leave the release agent layer to form the second dimming layer 152.

Step S404, forming the third dimming layer 153 on a side of the second dimming layer 152 away from the first dimming layer 151.

The above method makes the process for preparing the second dimming layer 152 simple, avoiding the use of vapor deposition or a sputtering process during the preparation of nano or submicron film layers of the display panel, thereby reducing the processes and improving the production efficiency of the display panel 100.

It should be noted that in order to achieve uniform residue of the second dimming layer 152 on the surface of the first dimming layer 151 away from the driving substrate 11 and/or on the surface of each of the second openings K2, it is necessary to perform the defoaming treatment in the above manufacturing process. If the defoaming treatment for the protective film is omitted in the manufacturing process, it is difficult to ensure the uniformity of the second dimming layer 152, which may lead to no residue of the second dimming layer 152 on the sidewall of each of the second openings K2, making it difficult to improve the light output efficiency of the display panel at the front viewing angle through total reflection.

In the above embodiments, the description of each embodiment has its own emphasis. For the parts that are not detailed in one embodiment, please refer to the relevant descriptions of other embodiments.

The above provides a detailed introduction to the technical solutions in the embodiments of the disclosure. Specific embodiments are applied in this context to explain the principles and implementation methods of the disclosure. The explanation of the above-mentioned embodiments is only used to help understand the technical solutions and core ideas of the disclosure. Ordinary skilled in the art should understand that they can still modify the technical solutions recited in the above-mentioned embodiments, or equivalently replace some of the technical features. These modifications or replacements do not separate the essence of corresponding technical solutions from the scope of the technical solutions of various embodiments of the disclosure.

## Claims

1. A display panel comprising:
a driving substrate;
a pixel definition layer and a light-emitting device layer disposed on the driving substrate, wherein the pixel definition layer is provided with a plurality of first openings, the light-emitting device layer comprises a plurality of light-emitting devices, and each of the light-emitting devices is disposed in one of the first openings;
an encapsulation layer disposed on a side of the light-emitting device layer away from the driving substrate; and
a dimming structure layer disposed on a side of the encapsulation layer away from the driving substrate, wherein the dimming structure layer comprises a first dimming layer, a second dimming layer, and a third dimming layer sequentially arranged in a direction away from the driving substrate; and the first dimming layer is provided with a plurality of second openings corresponding to the first openings, the second dimming layer at least covers a sidewall of the second openings, and the third dimming layer at least fills one of the second openings;
wherein a refractive index of the first dimming layer is greater than a refractive index of the second dimming layer and less than a refractive index of the third dimming layer.

2. The display panel of claim 1, wherein the first dimming layer is an organic layer, the second dimming layer at least comprises an organic substance, and the organic substance is different from a material of the organic layer.

3. The display panel of claim 2, wherein the organic substance comprises a moiety of -NHCOO-.

4. The display panel of claim 3, wherein a material of the second dimming layer comprises polyurethane.

5. The display panel of any one of claims 1 to 4, wherein the third dimming layer is an adhesive layer.

6. The display panel of claim 5, further comprising a polarization functional layer, wherein the polarization functional layer is disposed on a side of the dimming structure layer away from the encapsulation layer, and the adhesive layer is bonded to a surface of the polarization functional layer close to the dimming functional layer.

7. The display panel of claim 5, wherein the third dimming layer comprises an acrylic double bond and a benzene ring.

8. The display panel of claim 5, wherein the third dimming layer is doped with particles having a high refractive index.

9. The display panel of claim 5, wherein the third dimming layer comprises a polar functional group having low molecular weight to attach polyurethane.

10. The display panel of any one of claims 1 to 4, wherein an absolute value of a difference between the refractive index of the first dimming layer and the refractive index of the second dimming layer is less than an absolute value of a difference between the refractive index of the first dimming layer and the refractive index of the third dimming layer.

11. The display panel of claim 10, wherein the refractive index of the first dimming layer is greater than or equal to 1.5 and less than or equal to 1.53, the refractive index of the second dimming layer is greater than or equal to 1.4 and less than or equal to 1.5, and the refractive index of the third dimming layer is greater than or equal to 1.55 and less than or equal to 1.6.

12. The display panel of claim 11, wherein the refractive index of the first dimming layer is 1.52, the refractive index of the second dimming layer is 1.5, and the refractive index of the third dimming layer is 1.6.

13. The display panel of any one of claims 1 to 4, wherein the second dimming layer has a thickness greater than or equal to 10 nm and less than or equal to 100 nm.

14. The display panel of any one of claims 1 to 4, wherein the second dimming layer is disposed as a whole layer, and covers the first dimming layer and the second openings.

15. The display panel of any one of claims 1 to 4, wherein an orthographic projection of a bottom of one of the second openings on the driving substrate at least partially overlaps with an orthographic projection of corresponding one of the light-emitting devices on the driving substrate.

16. The display panel of claim 15, wherein the orthographic projection of the bottom of one of the second openings on the driving substrate covers the orthographic projection of corresponding one of the light-emitting devices on the driving substrate; or, the orthographic projection of the bottom of one of the second openings on the driving substrate completely overlaps with the orthographic projection of corresponding one of the light-emitting devices on the driving substrate.

17. The display panel of any one of claims 1 to 4, wherein the second openings penetrate through the first dimming layer, and an area of a side of one of the second openings away from the driving substrate is greater than an area of a side of one of the second openings close to the driving substrate.

18. A display device comprising the display panel as claimed in any one of claims 1 to 17.

19. A method for preparing a display panel comprising:
providing a driving substrate;
forming a pixel definition layer and a light-emitting device layer on the driving substrate, wherein the pixel definition layer is provided with a plurality of first openings, the light-emitting device layer comprises a plurality of light-emitting devices, and each of the light-emitting devices is disposed in one of the first openings;
forming an encapsulation layer on a side of the light-emitting device layer away from the driving substrate; and
forming a dimming structure layer on a side of the encapsulation layer away from the driving substrate, wherein the dimming structure layer comprises a first dimming layer, a second dimming layer, and a third dimming layer sequentially arranged in a direction away from the driving substrate; the first dimming layer is provided with a plurality of second openings corresponding to the first openings, the second dimming layer at least covers a sidewall of the second openings, and the third dimming layer at least fills one of the second openings; and a refractive index of the first dimming layer is greater than a refractive index of the second dimming layer and less than a refractive index of the third dimming layer.

20. The method for preparing the display panel of claim 19, wherein the step of forming a dimming structure layer on a side of the encapsulation layer away from the driving substrate comprises:
forming the first dimming layer on a side of the encapsulation layer away from the driving substrate, and forming the second openings on the first dimming layer;
applying a protective film on the first dimming layer and performing a defoaming treatment, wherein the protective film comprises a protective film body and a release agent layer disposed on a side of the protective film body close to the first dimming layer;
tearing off the protective film body to leave the release agent layer to form the second dimming layer, wherein the second dimming layer is disposed to at least cover the sidewall of the second openings; and
forming the third dimming layer on a side of the second dimming layer away from the first dimming layer.
